# EUROPEAN PATENT APPLICATION

(11) **EP 4 342 721 A1**
(43) Date of publication of application: **27.03.2024**
(21) Application number: 22874296.1
(22) Date of filing: 17.06.2022
(51) Int. Cl.: B60L 53/22, H02J 7/02, G01R 31/54, G01R 31/36

(54) **ON-BOARD CHARGER AND ELECTRIC VEHICLE**

(30) Priority: 29.09.2021 CN 202111157823
(71) Applicant: BYD Company Limited, Shenzhen, Guangdong 518118 (CN)
(72) Inventor: WANG, Xinghui, Shenzhen, Guangdong Province, 518118, P.R. China Guangdong 518118 (CN); WANG, Chao, Shenzhen, Guangdong Province, 518118, P.R. China Guangdong 518118 (CN); LIU, Weidong, Shenzhen, Guangdong Province, 518118, P.R. China Guangdong 518118 (CN)
(74) Representative: DehnsGermany Partnerschaft von Patentanwälten
(86) International application number: PCT/CN2022/099422
(87) International publication number: WO 2023/050899

(57) **Abstract**

The present disclosure discloses an on-board charger and an electric vehicle. The on-board charger includes a microprocessor and a DC module. A first sampling point is arranged between the DC module and a storage battery. A second sampling point is arranged between the storage battery and the microprocessor. The microprocessor is configured to: obtain a first voltage and a current value of the first sampling point, and obtain a second voltage of the second sampling point; and mark the connection between the storage battery and the DC module as cut off and record a first difference between the second voltage and the first voltage when the first voltage is greater than the second voltage and the current value is less than a preset current threshold.

## Description

### CROSS-REFERENCE TO RELATED APPLICATIONS

The present disclosure claims priority to Chinese Patent Application No. 202111157823.1, entitled "ON-BOARD CHARGER AND ELECTRIC VEHICLE" and filed on September 29, 2021. The entire content of the above-referenced application is incorporated herein by reference.

### FIELD

The present disclosure relates to the technical field of electric vehicles, and more specifically, to an on-board charger and an electric vehicle.

### BACKGROUND

As technologies develop, environmentally friendly and energy-saving electric vehicles are gradually replacing fuel vehicles. However, electric vehicles have some problems in popularization. If disconnection between a DC module configured to charge a storage battery and the storage battery is not detected in time, but the storage battery needs to continuously supply power to the outside, under voltage of the storage battery during travelling may be caused, resulting in low travelling safety and high travelling risks.

### SUMMARY

The present disclosure is intended to resolve at least one of the technical problems in the related art. A first purpose of the present disclosure is to provide an on-board charger. The on-board charger has advantages such as high disconnection detection accuracy.

In order to achieve the above purpose, an embodiment of a first aspect of the present disclosure provides an on-board charger. The on-board charger includes:
a DC module, a first end of the DC module being connected with a power battery, a second end of the DC module being connected with a storage battery, and a first sampling point being arranged between the storage battery and the DC module; and
a microprocessor, the microprocessor being connected with the storage battery, a second sampling point being arranged between the microprocessor and the storage battery, and the microprocessor being connected with the first sampling point and the second sampling point.

The microprocessor is configured to: obtain a first voltage and a current value of the first sampling point, and obtain a second voltage of the second sampling point; and
mark the connection between the storage battery and the DC module as cut off and record a first difference between the second voltage and the first voltage when the first voltage is greater than the second voltage and the current value is less than a preset current threshold.

In the present disclosure, the first sampling point is arranged between the DC module and the storage battery, and the second sampling point is arranged between the storage battery and the microprocessor. Therefore, in the present disclosure, it is determined whether the connection between the storage battery and the DC module is cut off based on a result of comparison between voltage sampling information of the first sampling point and voltage sampling information of the second sampling point and current sampling information of the first sampling point. In this way, disconnection detection accuracy is improved, and long-term continuous travelling in a case that the connection between the storage battery and the DC module of the electric vehicle is cut off is avoided, thereby improving travelling safety and reducing travelling risks.

A second purpose of the present disclosure is to provide an electric vehicle, which includes the on-board charger provided in the first purpose.

Additional aspects and advantages of the present disclosure will be given in the following description, some of which will become apparent from the following description or may be learned from practices of the present disclosure.

### BRIEF DESCRIPTION OF THE DRAWINGS

The above and/or additional aspects and advantages of the present disclosure will become apparent and comprehensible from the following descriptions of embodiments made with reference to the following drawings.
FIG. 1 is a schematic diagram of a framework structure of an on-board charger according to an embodiment of the present disclosure.
FIG. 2 is a schematic diagram of a topology of the on-board charger according to an embodiment of the present disclosure.

### DETAILED DESCRIPTION

Embodiments of the present disclosure are described in detail below, and the embodiments described with reference to drawings are exemplary.

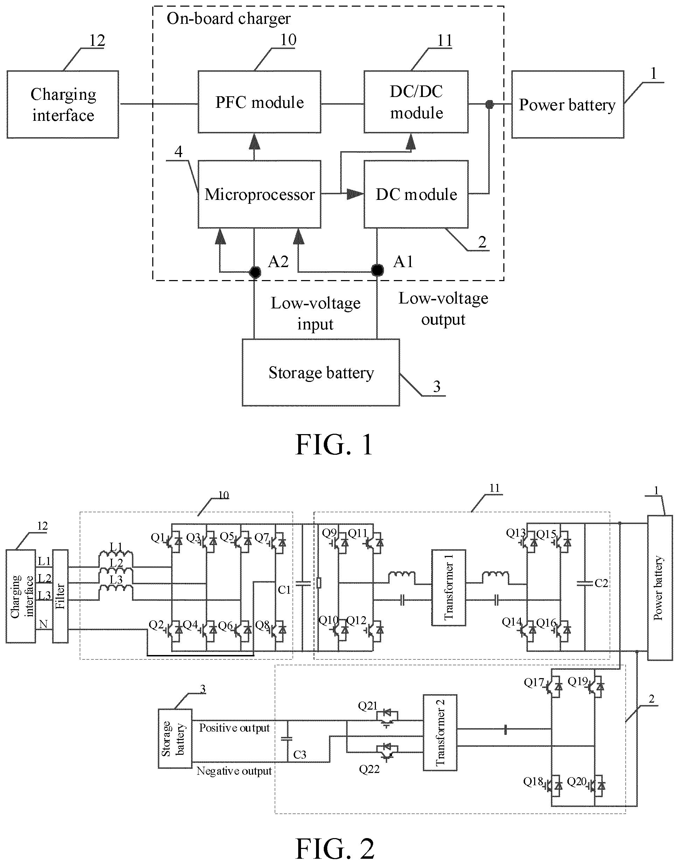

As shown in FIG. 1, an embodiment of the present disclosure provides an on-board charger. The on-board charger includes a DC module 2 and a microprocessor 4. A first end of the DC module 2 is connected with a power battery 1. A second end of the DC module 2 is connected with a storage battery 3. A first sampling point A1 is arranged between the storage battery 3 and the DC module 2. The microprocessor 4 is connected with the storage battery 3. A second sampling point A2 is arranged between the microprocessor 4 and the storage battery 3. The microprocessor 4 is connected with the first sampling point A1 and the second sampling point A2.

It should be noted that, in FIG. 1, a low-voltage control circuit of the on-board charger is described through arrows in the present disclosure.

The microprocessor 4 is configured to: obtain a first voltage and a current value of the first sampling point, and obtain a second voltage of the second sampling point; and mark the connection between the storage battery 3 and the DC module 2 as cut off and record a first difference between the second voltage and the first voltage when the first voltage is greater than the second voltage and the current value is less than a preset current threshold.

In the present disclosure, the first sampling point A1 is arranged between the DC module 2 and the storage battery 3, and the second sampling point A2 is arranged between the storage battery 3 and the microprocessor 4. Therefore, in the present disclosure, it is determined whether the connection between the storage battery 3 and the DC module 2 is cut off based on a result of comparison between voltage sampling information of the first sampling point A1 and voltage sampling information of the second sampling point A2 and current sampling information of the first sampling point. In this way, disconnection detection accuracy is improved, and long-term continuous travelling in a case that the connection between the storage battery 3 and the DC module 2 of the electric vehicle is cut off is avoided, thereby improving travelling safety and reducing travelling risks.

In order to further improve the disconnection determination accuracy, based on this embodiment, in other embodiments, the microprocessor 4 is further configured to:
control the DC module 2 to increase an output voltage of the DC module 2 when the connection between the storage battery 3 and the DC module 2 is marked as cut off; reobtain a third voltage of the first sampling point A1, reobtain a fourth voltage of the second sampling point A2, and obtain a second difference between the fourth voltage and the third voltage; determine that the connection between the storage battery 3 and the DC module 2 is cut off when a difference between the second difference and the first difference is greater than or equal to a preset threshold; and determine that the connection between the storage battery 3 and the DC module 2 is not cut off when the difference between the second difference and the first difference is less than the preset threshold.

In this embodiment, the DC module 2 is controlled to increase the output voltage of DC module 2, and it is determined whether the connection between the DC module 2 and the storage battery 3 is cut off based on re-sampled voltage sampling information. When the difference between the second difference and the first difference is less than the preset threshold, it is determined that the connection between the DC module 2 and the storage battery 3 is not cut off, which avoids erroneous disconnection determination. That is to say, erroneous determination of disconnection between the DC module 2 and the storage battery 3 in a case that an actual power supply current is very small and a sampling voltage of the second sampling point is less than a sampling voltage of the first sampling point as a result of a high impedance of a power supply circuit is avoided, thereby further improving the disconnection detection accuracy. In addition, when the difference between the second difference and the first difference is greater than or equal to the preset threshold, that is, when the voltage sampling information of the first sampling point A1 increases as a voltage of the DC module increases, but the voltage sampling information of the second sampling point decreases as the power supply to the outside proceeds, which results in a relatively large difference between the second difference and the first difference, reliability of determination of the disconnection between the storage battery 3 and the DC module 2 is improved.

Based on this embodiment, in other embodiments, the on-board charger further includes a PFC module 10 and a DC/DC module 11. A first end of the PFC module 10 is connected with a charging interface 12. A second end of the PFC module 10 is connected with a first end of the DC/DC module 11. A second end of the DC/DC module 11 is connected with the power battery 1 and the first end of the DC module 2.

Referring to FIG. 2, the charging interface 12 includes three L terminals and an N terminal. The PFC module 10 includes three inductors, three-phase high-frequency bridge arms, and one-phase power-frequency bridge arm. A first end of each of the inductors is connected with one of the L terminals. The other end is connected with a midpoint of one-phase high-frequency bridge arm. The N terminal is connected with a midpoint of the power-frequency bridge arm. Top ends of the three-phase high-frequency bridge arms and the one-phase power-frequency bridge arm are jointly connected to form a first confluent end. Bottom ends of the three-phase high-frequency bridge arms and the one-phase power-frequency bridge arm are jointly connected to form a second confluent end. The first end of the DC/DC module 11 is connected with the first confluent end and the second confluent end. The second end of the DC/DC module 11 is connected with the first end of the DC module 2 and the power battery 1.

Specifically, the three L terminals include an L1 terminal, an L2 terminal, and an L3 terminal. The three inductors include a first inductor L1, a second inductor L2, and a third inductor L3. The three-phase high-frequency bridge arms include a first phase high-frequency bridge arm (Q1+Q2), a second phase high-frequency bridge arm (Q3+Q4), and a third phase high-frequency bridge arm (Q5+Q6). A first end of the first inductor L1 is connected with the L1 terminal. A second end of the first inductor L1 is connected with a midpoint of the first phase high-frequency bridge arm. A first end of the second inductor L2 is connected with the L2 terminal. A second end of the second inductor L2 is connected with a midpoint of the second phase high-frequency bridge arm.

A first end of the third inductor L3 is connected with the L3 terminal. A second end of the third inductor L3 is connected with a midpoint of the third phase high-frequency bridge arm. The N terminal is connected with the midpoint of the one-phase power-frequency bridge arm (Q7+Q8). The top ends of the three-phase high-frequency bridge arms and the one-phase power-frequency bridge arm are jointly connected to form the first confluent end. The bottom ends of the three-phase high-frequency bridge arms and the one-phase power-frequency bridge arm are jointly connected to form the second confluent end.

The microprocessor 4 is further configured to: obtain a first phase and a first effective voltage corresponding to the first phase bridge arm, a second phase and a second effective voltage corresponding to the second phase bridge arm, and a third phase and a third effective voltage corresponding to the third phase bridge arm;
obtain a first phase difference between the first phase and the second phase, a second phase difference between the second phase and the third phase, and a third phase difference between the third phase and the first phase;
determine that an external power supply is a single-phase power supply or a three-phase power supply based on the first phase difference, the second phase difference, the third phase difference, the first effective voltage, the second effective voltage, and the third effective voltage;
control a single-phase charging mode to be enabled if it is determined that the external power supply is the single-phase power supply; and
control a three-phase charging mode to be enabled if it is determined that the external power supply is the three-phase power supply.

In this embodiment, both single-phase charging and three-phase charging are allowed. In addition, in the related art, in case of identification through only a phase difference, if phase detection is abnormal, erroneous determination occurs. Alternatively, in case of identification through only an effective voltage, if an obtained effective voltage is subject to interference, erroneous determination is caused. Therefore, in this embodiment, the single-phase/three-phase charging mode is identified with reference to the phase difference and the effective voltage, so that identification may be performed in another identification manner when identification through only the phase difference or only the effective voltage is inaccurate, thereby improving identification accuracy and reducing an erroneous determination rate.

In the above embodiment, the determination that the external power supply is the single-phase power supply or the three-phase power supply based on the first phase difference, the second phase difference, the third phase difference, the first effective voltage, the second effective voltage, and the third effective voltage includes at least the following implementations:
(1) Identification of single phase and three phase is performed first through the phase difference and then through the effective voltage.

Specifically, identification of single phase and three phase is performed first through the phase difference. When neither single-phase charging nor three-phase charging is identified through the phase difference, identification of single phase and three phase is performed through the effective voltage.

(2) Identification of single phase and three phase is performed first through the effective voltage and then through the phase difference.

Specifically, identification of single phase and three phase is performed first through the effective voltage. When neither single-phase charging nor three-phase charging is identified through the effective voltage, identification of single phase and three phase is performed through the phase difference.

(3) Identification of single phase or three phase is performed first through the phase difference and then through the effective voltage.

Specifically, identification of single phase is performed first through the phase difference. When single-phase charging is not identified through the phase difference, identification of single phase and three phase is performed through the effective voltage.

In addition, identification of three phase is performed first through the phase difference. When three-phase charging is not identified through the phase difference, identification of single phase and three phase is performed through the effective voltage.

(4) Identification of single phase or three phase is performed first through the effective voltage and then through the phase difference.

Specifically, identification of single phase is performed first through the effective voltage. When single-phase charging is not identified through the effective voltage, identification of single phase and three phase is performed through the phase difference.

In addition, identification of three phase is performed first through the effective voltage. When three-phase charging is not identified through the effective voltage, identification of single phase and three phase is performed through the phase difference.

Based on this embodiment, in other embodiments,

The microprocessor 4 is further configured to:
determine whether the first phase difference, the second phase difference, and the third phase difference all satisfy a preset charging mode determination condition; and determine that the external power supply is the single-phase power supply or the three-phase power supply based on the first effective voltage, the second effective voltage, and the third effective voltage when any of the first phase difference, the second phase difference, and the third phase difference does not satisfy the preset charging mode determination condition.

In this embodiment, the preset charging mode determination condition includes a preset three-phase charging determination condition; and the preset three-phase charging determination condition is that the first phase difference, the second phase difference, and the third phase difference all fall within a preset phase range.

In order to provide a more detailed description of the technical solutions of the present disclosure, the preset phase range may be preset or may be set in real time as required by a user. Exemplarily, the preset phase range may be (105°, 125°).

In addition, in this embodiment, the preset charging mode determination condition includes a preset single-phase charging determination condition; and the preset single-phase charging determination condition is that the first phase difference, the second phase difference, and the third phase difference are all less than a preset phase threshold.

In order to provide a more detailed description of the technical solutions of the present disclosure, the preset phase threshold may be preset or may be set in real time as required by a user. Exemplarily, the preset phase threshold may be 10°.

During the identification of the single-phase/three-phase charging mode in this embodiment, the identification is performed first through the phase difference and then through the effective voltage. Therefore, during identification through the phase difference, if the phase difference does not satisfy the preset three-phase charging determination condition, an operation of "determining whether the phase difference satisfies the preset single-phase charging determination condition" is directly abandoned, to avoid repeated invalid operations when the identification through the phase difference fails (for example, a phase loss or abnormal phase detection occurs), which simplifies the identification process, thereby improving an identification rate.

In addition, based on this embodiment, in other embodiments, during the identification through the phase difference, if the phase difference does not satisfy the preset single-phase charging determination condition, an operation of "determining whether the phase difference satisfies the preset three-phase charging determination condition" is directly abandoned, to avoid repeated invalid operations when the identification through the phase difference fails (for example, a phase loss or abnormal phase detection occurs), which simplifies the identification process, thereby improving the identification rate.

In addition, based on this embodiment, in other embodiments, the microprocessor 4 is further configured to:
determine whether the preset single-phase charging determination condition or the preset three-phase charging determination condition is satisfied based on the first effective voltage, the second effective voltage, and the third effective voltage; determine that the external power supply is the single-phase power supply if it is determined that the preset single-phase charging determination condition is satisfied; and determine that the external power supply is the three-phase power supply if it is determined that the preset three-phase charging determination condition is satisfied.

In this embodiment, the preset three-phase charging determination condition is: the first effective voltage > the second effective voltage > the third effective voltage > a first preset voltage threshold.

In order to provide a more detailed description of the technical solutions of the present disclosure, the first preset voltage threshold may be preset or may be set in real time as required by a user. Exemplarily, the first preset voltage threshold may be 150 V

In addition, in this embodiment, the preset single-phase charging determination condition is: the first effective voltage > the second effective voltage > the third effective voltage and the second effective voltage < a second preset voltage threshold.

In order to provide a more detailed description of the technical solutions of the present disclosure, the second preset voltage threshold may be preset or may be set in real time as required by a user. Exemplarily, the second preset voltage threshold may be 20 V

During the identification of the single-phase/three-phase charging mode in this embodiment, the identification is performed first through the effective voltage and then through the phase difference. Therefore, during the identification through the effective voltage, if the effective voltage does not satisfy the preset single-phase charging determination condition, an operation of "determining whether the effective voltage satisfies the preset three-phase charging determination condition" is directly abandoned, to avoid repeated invalid operations when the identification through the effective voltage fails (for example, a detected effective voltage is abnormal as a result of signal interference from hardware), which simplifies the identification process, thereby improving the identification rate.

In addition, during the identification through the phase difference, if the effective voltage does not satisfy the preset three-phase charging determination condition, an operation of "determining whether the effective voltage satisfies the preset single-phase charging determination condition" is directly abandoned, to avoid repeated invalid operations when the identification through the effective voltage fails (for example, a detected effective voltage is abnormal as a result of signal interference from hardware), which simplifies the identification process, thereby improving the identification rate.

A second aspect of the present disclosure provides an electric vehicle, which includes the on-board charger described in the embodiment of the first aspect.

Specific principles and implementations of the on-board charger of the electric vehicle provided in this embodiment of the present disclosure are similar to those in the above embodiment of the first aspect, and therefore the details are not described herein.

In the description of the present disclosure, it is to be understood that orientation or position relationships indicated by terms such as "center", "longitudinal", "transverse", "length", "width", "thickness", "upper", "lower", "front", "rear", "left", "right", "vertical", "horizontal", "top", "bottom", "interior", "exterior", "axial", and "circumferential" are based on orientation or position relationships shown in the drawings, are merely used to facilitate the description of the present disclosure and simplify the description, instead of indicating or implying that the indicated apparatus or element needs to have particular orientations or be constructed and operated in particular orientations, and therefore cannot be construed as a limitation on the present disclosure.

In the description of the present disclosure, it should be noted that, unless otherwise explicitly specified or defined, the terms such as "mount", "connect", and "connection" should be understood in a broad sense. For example, the connection may be a fixed connection, a detachable connection, or an integral connection; or the connection may be a direct connection, an indirect connection through an intermediary, or internal communication between two elements. A person of ordinary skill in the art may understand the specific meanings of the above terms in the present disclosure according to specific situations.

In the description of this specification, the description of the reference terms such as "an embodiment", "some embodiments", "exemplary embodiments", "example", "specific example", or "some examples" means that the specific features, structures, materials or characteristics described with reference to the embodiment or example are included in at least one embodiment or example of the present disclosure. In the present disclosure, exemplary descriptions of the above terms do not necessarily refer to the same embodiment or example.

Although the embodiments of the present disclosure have been shown and described, a person of ordinary skill in the art should understand that various changes, modifications, replacements, and variations may be made to the embodiments without departing from the principles and spirit of the present disclosure, and the scope of the present disclosure is as defined by the appended claims and their equivalents.

## Claims

1. An on-board charger, comprising:
a DC module, a first end of the DC module being connected with a power battery, a second end of the DC module being connected with a storage battery, and a first sampling point being arranged between the storage battery and the DC module; and
a microprocessor, the microprocessor being connected with the storage battery, a second sampling point being arranged between the microprocessor and the storage battery, and the microprocessor being connected with the first sampling point and the second sampling point; and
the microprocessor being configured to: obtain a first voltage and a current value of the first sampling point, and obtain a second voltage of the second sampling point; and
mark the connection between the storage battery and the DC module as cut off and record a first difference between the second voltage and the first voltage when the first voltage is greater than the second voltage and the current value is less than a preset current threshold.

2. The on-board charger according to claim 1, wherein the microprocessor is further configured to:
control the DC module to increase an output voltage of the DC module when the connection between the storage battery and the DC module is marked as cut off;
reobtain a third voltage of the first sampling point, reobtain a fourth voltage of the second sampling point, and obtain a second difference between the fourth voltage and the third voltage;
determine that the connection between the storage battery and the DC module is cut off when a difference between the second difference and the first difference is greater than or equal to a preset threshold; and
determine that the connection between the storage battery and the DC module is not cut off when the difference between the second difference and the first difference is less than the preset threshold.

3. The on-board charger according to claim 1 or 2, further comprising:
a PFC module, the PFC module comprising three inductors, three-phase high-frequency bridge arms, and one-phase power-frequency bridge arm, the PFC module being connected with a charging interface, the charging interface comprising three L terminals and an N terminal, a first end of each of the inductors being connected with one of the L terminals, the other end being connected with a midpoint of one-phase high-frequency bridge arm, the N terminal being connected with a midpoint of the power-frequency bridge arm, top ends of the three-phase high-frequency bridge arms and the one-phase power-frequency bridge arm being jointly connected to form a first confluent end, and bottom ends of the three-phase high-frequency bridge arms and the one-phase power-frequency bridge arm being jointly connected to form a second confluent end; and
a DC/DC module, a first end of the DC/DC module being connected with the first confluent end and the second confluent end, and a second end of the DC/DC module being connected with the first end of the DC module and the power battery; and
the microprocessor being further configured to: obtain a first phase and a first effective voltage corresponding to a first phase bridge arm, a second phase and a second effective voltage corresponding to a second phase bridge arm, and a third phase and a third effective voltage corresponding to a third phase bridge arm;
obtain a first phase difference between the first phase and the second phase, a second phase difference between the second phase and the third phase, and a third phase difference between the third phase and the first phase;
determine that an external power supply is a single-phase power supply or a three-phase power supply based on the first phase difference, the second phase difference, the third phase difference, the first effective voltage, the second effective voltage, and the third effective voltage;
control a single-phase charging mode to be enabled if it is determined that the external power supply is the single-phase power supply; and
control a three-phase charging mode to be enabled if it is determined that the external power supply is the three-phase power supply.

4. The on-board charger according to any of claims 1 to 3, wherein the microprocessor is further configured to:
determine whether the first phase difference, the second phase difference, and the third phase difference all satisfy a preset charging mode determination condition; and
determine that the external power supply is the single-phase power supply or the three-phase power supply based on the first effective voltage, the second effective voltage, and the third effective voltage when any of the first phase difference, the second phase difference, and the third phase difference does not satisfy the preset charging mode determination condition.

5. The on-board charger according to any of claims 1 to 4, wherein the preset charging mode determination condition comprises a preset three-phase charging determination condition; and the preset three-phase charging determination condition is that the first phase difference, the second phase difference, and the third phase difference all fall within a preset phase range.

6. The on-board charger according to any of claims 1 to 5, wherein the preset charging mode determination condition comprises a preset single-phase charging determination condition; wherein the preset single-phase charging determination condition is that the first phase difference, the second phase difference, and the third phase difference are all less than a preset phase threshold.

7. The on-board charger according to any of claims 1 to 6, wherein the microprocessor is further configured to:
determine whether the preset single-phase charging determination condition or the preset three-phase charging determination condition is satisfied based on the first effective voltage, the second effective voltage, and the third effective voltage;
determine that the external power supply is the single-phase power supply if it is determined that the preset single-phase charging determination condition is satisfied; and
determine that the external power supply is the three-phase power supply if it is determined that the preset three-phase charging determination condition is satisfied.

8. The on-board charger according to any of claims 1 to 7, wherein the preset three-phase charging determination condition is: the first effective voltage > the second effective voltage > the third effective voltage > a first preset voltage threshold.

9. The on-board charger according to any of claims 1 to 8, wherein the preset single-phase charging determination condition is: the first effective voltage > the second effective voltage > the third effective voltage and the second effective voltage < a second preset voltage threshold.

10. An electric vehicle, comprising the on-board charger according to any of claims 1 to 9.
